# FASCICULE DE BREVET EUROPEEN

(11) **EP 3 987 663 B1**
(45) Date de publication et mention de la délivrance du brevet: **09.08.2023**
(21) Numéro de dépôt: 20731897.3
(22) Date de dépôt: 16.06.2020
(51) Int. Cl.: B06B 1/02, B06B 1/06

(54) **DISPOSITIF D'IMAGERIE ULTRASONORE MATRICIEL**
ULTRASCHALLBILDSENSOR MIT MATRIXSTRUKTUR
MATRIX ULTRASONIC IMAGING DEVICE

(30) Priorité: 18.06.2019 FR 1906515
(43) Date de publication de la demande: 27.04.2022
(73) Titulaire: Moduleus, 37100 Tours (FR)
(72) Inventeur: CHATAIN, Pascal, 37170 CHAMBRAY-LES-TOURS (FR); JEANNE, Edgard, 37000 TOURS (FR)
(74) Mandataire: Cabinet Beaumont
(86) Numéro de dépôt international: PCT/EP2020/066632
(87) Numéro de publication internationale: WO 2020/254325

(56) Documents cités:
- WO-A1-99/49787
- FR-A1- 3 061 616
- FR-A1- 3 063 003

## Description

La présente demande de brevet revendique la priorité de la demande de brevet français FR19/06515.

### Domaine technique

La présente description concerne le domaine de l'imagerie ultrasonore, et vise plus particulièrement un dispositif comportant une matrice de transducteurs ultrasonores et un circuit électronique de commande de ces transducteurs.

### Technique antérieure

Un dispositif d'imagerie ultrasonore comprend classiquement une pluralité de transducteurs ultrasonores, et un circuit électronique de commande connecté aux transducteurs comme décrite par exemple dans le document FR 3 063 003 A1. En fonctionnement, l'ensemble des transducteurs est disposé face à un corps dont on souhaite acquérir une image. Le circuit électronique de commande est configuré pour appliquer des signaux électriques d'excitation aux transducteurs, de façon à provoquer l'émission d'ondes ultrasonores par les transducteurs, en direction du corps à analyser. Les ondes ultrasonores émises par les transducteurs sont réfléchies par le corps à analyser (par sa structure interne et/ou superficielle), puis reviennent vers les transducteurs qui les convertissent à nouveau en signaux électriques. Ces signaux électriques de réponse sont lus par le circuit électronique de commande, et peuvent être mémorisés et analysés pour en déduire des informations sur le corps étudié.

Les transducteurs ultrasonores peuvent être disposés en barrette dans le cas de dispositifs d'acquisition d'images bidimensionnelles, ou en matrice dans le cas de dispositifs d'acquisition d'images tridimensionnelles. Dans le cas d'un dispositif d'acquisition d'images bidimensionnelles, l'image acquise est représentative d'une coupe du corps étudié dans un plan défini par l'axe d'alignement des transducteurs de la barrette d'une part, et par la direction d'émission des transducteurs d'autre part. Dans le cas d'un dispositif d'acquisition d'images tridimensionnelles, l'image acquise est représentative d'un volume défini par les deux directions d'alignement des transducteurs de la matrice et par la direction d'émission des transducteurs.

Parmi les dispositifs d'acquisition d'images tridimensionnelles, on peut distinguer les dispositifs dits entièrement peuplés ("fully populated" en langue anglaise), dans lesquels chaque transducteur de la matrice est adressable individuellement, et les dispositifs dits à adressage ligne-colonne ou RCA (de l'anglais "Row-Column Adressing"), dans lesquels les transducteurs de la matrice sont adressables par ligne et par colonne.

Les dispositifs entièrement peuplés offrent une plus grande flexibilité dans la mise en forme des faisceaux ultrasonores en émission et en réception. L'électronique de commande de la matrice est toutefois complexe, le nombre de canaux d'émission/réception requis étant égal à M*N dans le cas d'une matrice de M lignes par M colonnes. De plus, le rapport signal sur bruit est généralement relativement faible dans la mesure où chaque transducteur présente une faible surface d'exposition aux ondes ultrasonores.

Les dispositifs de type RCA utilisent des algorithmes de mise en forme des faisceaux ultrasonores différents. Les possibilités de mise en forme des faisceaux peuvent être réduites par rapport aux dispositifs entièrement peuplés. Toutefois, l'électronique de commande de la matrice est considérablement simplifiée, le nombre de canaux d'émission/réception requis étant réduite à M+N dans le cas d'une matrice de M lignes par N colonnes. De plus, le rapport signal sur bruit est amélioré du fait de l'interconnexion des transducteurs en ligne ou en colonne lors des phases d'émission et de réception.

On s'intéresse ici plus particulièrement aux dispositifs d'acquisition d'images tridimensionnelles à adressage ligne-colonne (RCA).

### Résumé de l'invention

L' invention est défini par le contenu de la revendication 1. Un objet d'un mode de réalisation est de prévoir un dispositif d'acquisition d'images ultrasonores tridimensionnelles palliant tout ou partie des inconvénients des dispositifs connus.

Pour cela, un mode de réalisation prévoit un dispositif d'imagerie ultrasonore, comportant :
- une pluralité de transducteurs ultrasonores agencés en matrice selon des rangées et des colonnes, chaque transducteur comportant une première électrode et une deuxième électrode, les premières électrodes des transducteurs d'une même ligne étant interconnectées et les deuxièmes électrodes des transducteurs d'une même colonne étant interconnectées ;
- pour chaque ligne, un circuit d'émission, un circuit de réception, et un commutateur commandable pour, dans une première configuration, connecter les premières électrodes des transducteurs de la ligne au circuit d'émission de la ligne, et, dans une deuxième configuration, connecter les premières électrodes des transducteurs de la ligne au circuit de réception de la ligne ;
- pour chaque colonne, un circuit d'émission, un circuit de réception, et un commutateur commandable pour, dans une première configuration, connecter les deuxièmes électrodes des transducteurs de la colonne au circuit d'émission de la colonne, et, dans une deuxième configuration, connecter les deuxièmes électrodes des transducteurs de la colonne au circuit de réception de la colonne ; et

- un circuit de contrôle configuré pour :
   lors d'une première phase d'émission, commander les commutateurs d'une ligne et d'une colonne dans la première configuration, commander le circuit d'émission de la ligne pour appliquer un signal de polarisation continu sur les premières électrodes des transducteurs de la ligne, et commander le circuit d'émission de la colonne pour appliquer un signal d'excitation variable sur les deuxièmes électrodes des transducteurs de la colonne ; et/ou
   lors d'une première phase de réception, commander les commutateurs d'une ligne et d'une colonne respectivement dans la première configuration et dans la deuxième configuration, commander le circuit d'émission de la ligne pour appliquer un signal de polarisation continu sur les premières électrodes des transducteurs de la ligne, et commander le circuit de réception de la colonne pour lire un signal de réponse variable sur les deuxièmes électrodes des transducteurs de la colonne.

Selon un mode de réalisation, le circuit de contrôle est en outre configuré pour :
lors d'une deuxième phase d'émission, commander les commutateurs d'une ligne et d'une colonne dans la première configuration, commander le circuit d'émission de la colonne pour appliquer un signal de polarisation continu sur les deuxièmes électrodes des transducteurs de la colonne, et commander le circuit d'émission de la ligne pour appliquer un signal d'excitation variable sur les premières électrodes des transducteurs de la ligne ; et/ou
lors d'une deuxième phase de réception, commander les commutateurs d'une ligne et d'une colonne respectivement dans la deuxième configuration et dans la première configuration, commander le circuit d'émission de la colonne pour appliquer un signal de polarisation continu sur les deuxièmes électrodes des transducteurs de la colonne, et commander le circuit de réception de la colonne pour lire un signal de réponse variable sur les premières électrodes des transducteurs de la ligne.

Selon un mode de réalisation :
- dans chaque ligne, le commutateur de la ligne est en outre commandable pour, dans une troisième configuration, connecter les premières électrodes des transducteurs de la ligne à un noeud d'application d'un potentiel de polarisation fixe ; et
- dans chaque colonne, le commutateur de la colonne est en outre commandable pour, dans une troisième configuration, connecter les deuxièmes électrodes des transducteurs de la colonne audit noeud d'application d'un potentiel de polarisation fixe.

Selon un mode de réalisation :
- les commutateurs des différentes lignes ont des bornes de commande communes ; et
- les commutateurs des différentes colonnes ont des bornes de commande communes.

Selon un mode de réalisation :
- les commutateurs des différentes lignes ont des bornes de commande différenciées ; et
- les commutateurs des différentes colonnes ont des bornes de commande différenciées.

Selon un mode de réalisation, les transducteurs ultrasonores sont des transducteurs CMUT ou des transducteurs PMUT.

Selon un mode de réalisation, les commutateurs sont co-intégrés de façon monolithique avec la matrice de transducteurs ultrasonores.

Selon un mode de réalisation, chaque commutateur comprend des premier et deuxième interrupteurs MEMS à commande électrostatique.

Selon un mode de réalisation :
- pour chaque ligne, les premier et deuxième interrupteurs du commutateur de la ligne sont disposés respectivement aux deux extrémités de la ligne ; et
- pour chaque colonne, les premier et deuxième interrupteurs du commutateur de la colonne sont disposés respectivement aux deux extrémités de la colonne.

Selon un mode de réalisation :
- pour chaque ligne, les premier et deuxième interrupteurs du commutateur de la ligne sont disposés du côté d'une même extrémité de la ligne ; et
- pour chaque colonne, les premier et deuxième interrupteurs du commutateur de la colonne sont disposés du côté d'une même extrémité de la colonne.

Selon un mode de réalisation, chaque commutateur comprend en outre un troisième interrupteur MEMS à commande électrostatique, et :
- pour chaque ligne, le troisième interrupteur du commutateur de la ligne est disposé du côté de la même extrémité de la ligne que le premier interrupteur de la ligne, ou du côté de l'extrémité de la ligne opposée au premier interrupteur de la ligne ; et
- pour chaque colonne, le troisième interrupteur du commutateur de la colonne est disposé du côté de la même extrémité de la colonne que le premier interrupteur de la colonne, ou du côté de l'extrémité de la colonne opposée au premier interrupteur de la colonne.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'un dispositif d'imagerie matriciel selon un mode de réalisation ;
la figure 2 est un chronogramme illustrant un exemple d'un procédé de commande du dispositif de la figure 1 ;
la figure 3 illustre un exemple de réalisation d'un interrupteur du dispositif de la figure 1 ;
la figure 4 représente de façon schématique et partielle un premier exemple de réalisation du dispositif de la figure 1 ;
la figure 5 représente de façon schématique et partielle un deuxième exemple de réalisation du dispositif de la figure 1 ;
la figure 6 représente de façon schématique et partielle un troisième exemple de réalisation du dispositif de la figure 1 ; et
la figure 7 est une vue en coupe schématique et partielle du dispositif de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications que peuvent avoir les dispositifs d'imagerie décrits n'ont pas été détaillées, les modes de réalisation décrits étant compatibles avec les applications usuelles des dispositifs d'imagerie ultrasonore. De plus, les propriétés (fréquences, formes, amplitudes, etc.) des signaux électriques d'excitation appliqués par le circuit de commande aux transducteurs ultrasonores n'ont pas été détaillées, les modes de réalisation décrits étant compatibles avec les signaux d'excitation usuellement utilisés dans les systèmes d'imagerie ultrasonore, qui peuvent être choisis en fonction de l'application considérée et en particulier de la nature du corps à analyser et du type d'information que l'on cherche à acquérir. De façon similaire, les divers traitements appliqués aux signaux électriques fournis par les transducteurs ultrasonores et lus par le circuit de commande pour extraire des informations utiles sur le corps à analyser n'ont pas été détaillés, les modes de réalisation décrits étant compatibles avec les traitements usuellement utilisés dans les systèmes d'imagerie ultrasonore. De plus, la réalisation des transducteurs ultrasonores et du circuit de commande des dispositifs d'imagerie décrits n'a pas été détaillée, la réalisation détaillée de ces éléments étant à la portée de l'homme du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

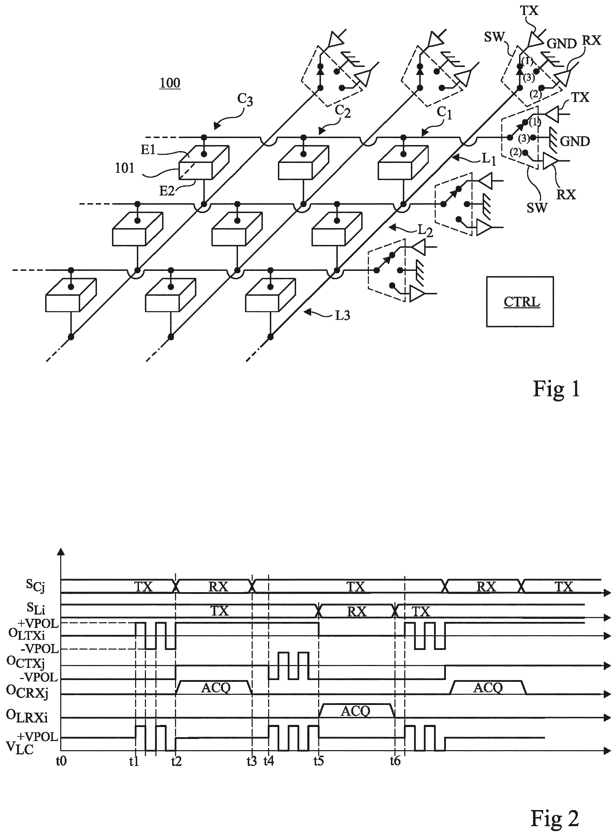

La figure 1 est un schéma électrique d'un exemple d'un dispositif d'imagerie matriciel 100 selon un mode de réalisation.

Le dispositif 100 comprend une pluralité de transducteurs ultrasonores 101 agencés en matrice selon M lignes Lᵢ et N colonnes Cⱼ, avec M et N entiers supérieurs ou égaux à deux, i entier allant de 1 à M, et j entier allant de 1 à N.

Chaque transducteur 101 comprend deux électrodes E1 et E2. Lorsqu'une tension d'excitation appropriée est appliquée entre les électrodes E1 et E2, le transducteur émet une onde acoustique ultrasonore. Lorsque le transducteur reçoit une onde acoustique ultrasonore dans une certaine gamme de fréquences, il fournit entre ses électrodes E1 et E2 une tension représentative de l'onde reçue.

Dans cet exemple, les transducteurs 101 sont des transducteurs de type CMUT (transducteurs ultrasonores capacitifs à membrane).

Dans chaque ligne Lᵢ de la matrice de transducteurs, les transducteurs 101 de la ligne ont leurs électrodes E1 respectives connectées entre elles. Les électrodes E1 de transducteurs 101 de lignes distinctes ne sont en revanche pas connectées entre elles. De plus, dans chaque colonne Cⱼ de la matrice de transducteurs, les transducteurs 101 de la colonne ont leurs électrodes E2 respectives connectées entre elles. Les électrodes E2 de transducteurs 101 de colonnes distinctes ne sont en revanche pas connectées entre elles.

Pour chaque ligne Lᵢ de la matrice de transducteurs, le dispositif 100 comprend un circuit d'émission TX, un circuit de réception RX, et un commutateur SW commandable pour, dans une première configuration (1), connecter les électrodes E1 des transducteurs de la ligne à une borne de sortie du circuit d'émission TX de la ligne, et, dans une deuxième configuration (2), connecter les électrodes E1 des transducteurs de la ligne à une borne d'entrée du circuit de réception RX de la ligne.

De plus, pour chaque colonne Cⱼ de la matrice de transducteurs, le dispositif 100 comprend un circuit d'émission TX, un circuit de réception RX, et un commutateur SW commandable pour, dans une première configuration (1), connecter les électrodes E2 des transducteurs de la colonne à une borne de sortie du circuit d'émission TX de la colonne, et, dans une deuxième configuration (2), connecter les électrodes E2 des transducteurs de la colonne à une borne d'entrée du circuit de réception RX de la colonne.

Pour chaque ligne Lᵢ, le commutateur SW de la ligne peut en outre être commandable pour, dans une troisième configuration (3), connecter les électrodes E1 des transducteurs de la ligne à un noeud d'application d'un potentiel de polarisation fixe GND, par exemple la masse. De plus, pour chaque colonne Cⱼ, le commutateur SW de la colonne peut être commandable pour, dans une troisième configuration (3), connecter les électrodes E2 des transducteurs de la colonne au noeud GND.

Le dispositif 100 comprend en outre un circuit de contrôle CTRL adapté à commander les commutateurs SW et les circuits d'émission TX, et à lire les signaux fournis par les circuits de réception RX. Le circuit de contrôle CTRL forme, avec les circuits d'émission TX et de réception RX et avec les commutateurs SW, un circuit de commande de la matrice de transducteurs 101.

Chaque circuit d'émission TX comprend par exemple un générateur d'impulsions ayant une borne de sortie reliée, par exemple connectée, à la borne de sortie du circuit TX, et une borne d'entrée de commande reliée, par exemple connectée, à une borne de sortie du circuit de contrôle CTRL. Chaque circuit de réception RX peut comprendre un amplificateur, de préférence un amplificateur à faible bruit, ayant une borne d'entrée reliée, par exemple connectée, à la borne d'entrée du circuit RX, et une borne de sortie reliée, par exemple connectée, à une borne d'entrée du circuit de contrôle CTRL.

Pour émettre et/ou recevoir une onde ultrasonore, un transducteur de type CMUT doit généralement être polarisé. Pour cela, une tension de polarisation continue est appliquée entre ses électrodes E1 et E2, tandis qu'une tension d'excitation variable (i.e. non continue) est appliquée sur l'une de ses électrodes E1 et E2 ou qu'une tension de réponse variable est lue sur l'une de ses électrodes E1 et E2.

Dans les dispositifs d'imagerie ultrasonore connus, la tension de polarisation est fournie par un circuit de polarisation spécifique, distinct des circuits d'émission et de réception, et un condensateur de découplage est prévu pour isoler le circuit de polarisation des circuits d'émission et de réception. La prévision du circuit de polarisation et du condensateur de découplage ajoute toutefois à la complexité et au coût du circuit de commande du dispositif. De plus, la présence du condensateur de découplage peut entraîner des couplages parasites entre les différents transducteurs du dispositif. En particulier, la présence du condensateur de découplage limite significativement les possibilités de commutation dynamiques des lignes et des colonnes, et par conséquent la capacité de la matrice à balayer efficacement les deux plans orthogonaux à l'axe de propagation des ondes ultrasonores. Ceci conduit en pratique à une inhomogénéité dans la reconstruction du volume étudié.

Selon un aspect d'un mode de réalisation, dans le dispositif 100 de la figure 1, la polarisation des transducteurs ultrasonores est assurée directement par les circuits d'émission TX du circuit de commande. Ceci permet de se passer d'un circuit spécifique de polarisation des transducteurs 101, et d'un condensateur de découplage pour isoler le circuit de polarisation des circuits d'émission RX et de réception TX.

Lors d'une phase d'émission d'une onde ultrasonore au moyen d'un transducteur 101 du dispositif 100, le circuit de contrôle CTRL commande les commutateurs SW connectés à l'électrode E1 et à l'électrode E2 du transducteur 101 dans la première configuration (1), de façon à connecter les électrodes E1 et E2 du transducteur 101 respectivement au circuit d'émission TX de la ligne Lᵢ à laquelle appartient le transducteur, et au circuit d'émission TX de la colonne Cⱼ à laquelle appartient le transducteur 101. Le circuit de contrôle CTRL commande alors le circuit d'émission TX de la ligne Lᵢ à laquelle appartient le transducteur pour appliquer une tension de polarisation continue sur l'électrode E1 du transducteur, et commande simultanément le circuit d'émission TX de la colonne Cⱼ à laquelle appartient le transducteur pour appliquer une tension d'excitation variable, par exemple une tension alternative, sur l'électrode E2 du transducteur.

Lors d'une phase de réception d'une onde ultrasonore au moyen d'un transducteur 101 du dispositif 100, le circuit de contrôle CTRL commande les commutateurs SW connectés à l'électrode E1 et à l'électrode E2 du transducteur 101 respectivement dans la première configuration (1) et dans la deuxième configuration (2), de façon à connecter les électrodes E1 et E2 du transducteur 101 respectivement au circuit d'émission TX de la ligne Lᵢ à laquelle appartient le transducteur, et au circuit de réception RX de la colonne Cⱼ à laquelle appartient le transducteur 101. Le circuit de contrôle CTRL commande alors le circuit d'émission TX de la ligne Lᵢ à laquelle appartient le transducteur pour appliquer une tension de polarisation continue sur l'électrode E1 du transducteur, et commande simultanément le circuit de réception RX de la colonne Cⱼ à laquelle appartient le transducteur pour lire une tension alternative de réponse sur l'électrode E2 du transducteur.

A titre de variante, la tension de polarisation continue peut être appliquée sur l'électrode E2, la tension variable d'excitation et la tension variable de réponse étant alors respectivement appliquée et lue sur l'électrode E1.

Dans une autre variante, la tension de polarisation continue peut être appliquée sur l'une des électrodes E1 et E2 pendant la phase d'émission, puis sur l'autre électrode pendant la phase de réception. A titre d'exemple, pendant la phase d'émission, la tension de polarisation continue est appliquée sur l'électrode E1 et la tension variable d'excitation est appliquée sur l'électrode E2, et, pendant la phase de réception, la tension de polarisation continue est appliquée sur l'électrode E2 et la tension variable de réponse est lue sur l'électrode E1.

La figure 2 est un chronogramme illustrant schématiquement un exemple d'un procédé de commande du dispositif 100 de la figure 1, pouvant être mis en oeuvre par le circuit de contrôle CTRL. On considère plus particulièrement dans cet exemple une ligne Lᵢ et une colonne Cⱼ de la matrice de transducteurs 101. La figure 2 représente l'évolution, en fonction du temps, d'un signal S_{Cj} de commande du commutateur SW de la colonne Cⱼ, d'un signal S_{Li} de commande du commutateur SW de la ligne Lᵢ, de la tension O_{LTXi} délivrée par le circuit d'émission TX de la ligne Lᵢ, de la tension O_{CTXj} délivrée par le circuit d'émission TX de la colonne Cⱼ, de la tension O_{CRXj} délivrée par le circuit de réception RX de la colonne Cⱼ, de la tension O_{LRXi} délivrée par le circuit de réception RX de la ligne Lᵢ, et de la tension V_{LC} entre les électrodes E1 des transducteurs de la ligne Lᵢ et les électrodes E2 des transducteurs de la colonne Cⱼ. On notera que, par souci de simplification, les signaux S_{Cj} et S_{Li} ne sont pas détaillés sur la figure 2. Plus particulièrement, pour chacun des signaux S_{Cj} et S_{Li}, on a simplement représenté un état 'TX' correspondant à un état de commande du commutateur SW dans la première configuration (connexion au circuit d'émission TX), et un état 'RX' correspondant à un état de commande du commutateur SW dans la deuxième configuration (connexion au circuit de réception RX). De plus, par souci de simplification, les signaux de réponse O_{CRXj} et O_{LRXi} délivrés par les circuits de réception RX pendant les phases de réception ne sont pas détaillés sur la figure 2. Plus particulièrement, pour chacun des signaux O_{CRXj} et O_{LRXi}, on a simplement représenté un état 'ACQ' correspondant à la fourniture d'un signal variable par le circuit RX pendant une phase de réception d'un signal ultrasonore.

A partir d'un instant t0 et jusqu'à un instant t1 postérieur à l'instant t0, le commutateur SW de la colonne Cⱼ et le commutateur SW de la ligne Lᵢ sont tous deux commandés dans la première configuration (TX), de façon à connecter les électrodes E1 des transducteurs de la ligne Lᵢ au circuit d'émission TX de la ligne Lᵢ, et les électrodes E2 des transducteurs de la colonne Cⱼ au circuit d'émission TX de la colonne Cⱼ. Le circuit d'émission TX de la ligne Lᵢ est commandé pour appliquer une tension O_{LTXi} continue sensiblement nulle sur les électrodes E1 des transducteurs de la ligne Lᵢ, et le circuit d'émission TX de la colonne Cⱼ est commandé pour appliquer une tension O_{CTXj} de polarisation continue négative -V_{POL}, par exemple de l'ordre de -10 volts, sur les électrodes E2 des transducteurs de la colonne Cⱼ. La tension V_{LC} est alors une tension continue positive égale à +V_{POL}. En l'absence de connexion des circuits de réception RX aux électrodes E1 et E2, les tensions O_{CRXj} et O_{LRXi} fournies respectivement par le circuit de réception RX de la colonne Cⱼ et par le circuit de réception de la ligne Lᵢ sont sensiblement nulles.

A partir de l'instant t1 et jusqu'à un instant t2 postérieur à l'instant t1, le circuit de contrôle CTRL commande le circuit d'émission TX de la ligne Lᵢ pour appliquer un signal d'excitation variable, par exemple une suite d'impulsions de tension positives et/ou négatives, sur les électrodes E1 des transducteurs 101 de la ligne Lᵢ. Dans l'exemple représenté, le signal d'excitation correspond à une alternance d'impulsions de tension positives en créneaux de valeur V_{POL} et d'impulsions de tension négatives en créneaux de valeur -V_{POL}. La tension V_{LC} est ainsi une tension en créneaux alternant entre 0 volt et 2*V_{POL}.

Les instants t1 et t2 marquent respectivement le début et la fin d'une phase d'émission d'une onde ultrasonore par le transducteur 101 commun à la ligne Lᵢ et à la colonne Cⱼ. En pratique, la tension continue de polarisation -V_{POL} peut également être appliquée sur les électrodes E2 des transducteurs 101 des autres colonnes du dispositif. Dans ce cas, pendant la phase d'émission allant de l'instant t1 à l'instant t2, une onde ultrasonore est émise par l'ensemble des transducteurs 101 de la ligne Lᵢ.

A partir de l'instant t2 et jusqu'à un instant t3 postérieur à l'instant t2, le commutateur SW de la colonne Cⱼ est commandé dans la deuxième configuration (RX), de façon à connecter les électrodes E2 des transducteurs de la colonne Cⱼ au circuit de réception RX de la colonne. Le commutateur SW de la ligne Lᵢ est quant à lui maintenu dans la première configuration (TX). Le circuit d'émission TX de la ligne Lᵢ est commandé pour appliquer une tension O_{LTXi} continue positive +V_{POL} sur les électrodes E1 des transducteurs de la ligne Lᵢ. En négligeant les oscillations liées à la réception de l'onde ultrasonore retour par les transducteurs (en pratique, l'amplitude du signal retour issu de la conversion acousto-électrique est inférieure d'au moins quatre ordres de grandeur à l'amplitude du signal d'excitation, soit 80 dB plus faible), la tension V_{LC} est alors une tension continue positive égale à +V_{POL} .

Les instants t2 et t3 marquent respectivement le début et la fin d'une phase de réception d'une onde ultrasonore retour par le transducteur 101 commun à la ligne Lᵢ et à la colonne Cⱼ. Pendant la phase de réception, la tension O_{CRXj} fournie par le circuit de réception RX de la colonne Cⱼ est représentative de l'onde ultrasonore reçue par le transducteur 101 commun à la ligne Lᵢ et à la colonne Cⱼ. La tension O_{CRXj} peut être lue par le circuit de contrôle CTRL. En pratique, pendant la phase de réception, la tension continue de polarisation V_{POL} peut également être appliquée sur les électrodes E1 des transducteurs 101 des autres lignes du dispositif. Dans ce cas, la tension O_{CRXj} est représentative de l'onde ultrasonore retour reçue par l'ensemble des transducteurs 101 de la colonne Cⱼ.

On a en outre représenté sur la figure 2, après l'instant t3, un deuxième exemple de mise en oeuvre de phases d'émission et de réception d'ondes ultrasonores par le dispositif 100. Dans ce deuxième exemple, les électrodes d'application des tensions de polarisation continues et les électrodes d'application des signaux d'excitation et de lecture des signaux retour sont inversées par rapport à l'exemple qui vient d'être décrit.

A partir de l'instant t3 et jusqu'à un instant t4 postérieur à l'instant t3, le commutateur SW de la colonne Cⱼ et le commutateur SW de la ligne Lᵢ sont tous deux commandés dans la première configuration (TX). Le circuit d'émission TX de la colonne Cⱼ est commandé pour appliquer une tension O_{CTXj} continue sensiblement nulle sur les électrodes E2 des transducteurs de la colonne Cⱼ, et le circuit d'émission TX de la ligne Lᵢ est commandé pour appliquer une tension O_{LTXi} de polarisation continue positive +V_{POL} sur les électrodes E1 des transducteurs de la ligne Lᵢ. La tension V_{LC} est alors une tension continue positive égale à +V_{POL}.

A partir de l'instant t4 et jusqu'à un instant t5 postérieur à l'instant t4, le circuit de contrôle CTRL commande le circuit d'émission TX de la colonne Cⱼ pour appliquer un signal d'excitation variable sur les électrodes E2 des transducteurs 101 de la colonne Cⱼ.

Les instants t4 et t5 marquent respectivement le début et la fin d'une phase d'émission d'une onde ultrasonore par le transducteur 101 commun à la ligne Lᵢ et à la colonne Cⱼ. En pratique, la tension continue de polarisation +V_{POL} peut également être appliquée sur les électrodes E1 des transducteurs 101 des autres lignes du dispositif. Dans ce cas, pendant la phase d'émission allant de l'instant t4 à l'instant t5, une onde ultrasonore est émise par l'ensemble des transducteurs 101 de la colonne Cⱼ.

A partir de l'instant t5 et jusqu'à un instant t6 postérieur à l'instant t5, le commutateur SW de la ligne Lᵢ est commandé dans la deuxième configuration (RX), de façon à connecter les électrodes E1 des transducteurs de la ligne Lᵢ au circuit de réception RX de la ligne. Le commutateur SW de la colonne Cⱼ est quant à lui maintenu dans la première configuration (TX). Le circuit d'émission TX de la colonne Cⱼ est commandé pour appliquer une tension O_{CTXj} continue négative -V_{POL} sur les électrodes E2 des transducteurs de la colonne Cⱼ. En négligeant les oscillations liées à la réception de l'onde ultrasonore retour, la tension V_{LC} est alors une tension continue positive égale à +V_{POL}.

Les instants t5 et t6 marquent respectivement le début et la fin d'une phase de réception d'une onde ultrasonore retour par le transducteur 101 commun à la ligne Lᵢ et à la colonne Cⱼ. Pendant la phase de réception, la tension O_{LRXi} fournie par le circuit de réception RX de la ligne Lᵢ est représentative de l'onde ultrasonore retour reçue par le transducteur 101 commun à la ligne Lᵢ et à la colonne Cⱼ. La tension O_{LRXi} peut être lue par le circuit de contrôle CTRL. En pratique, pendant la phase de réception, la tension continue de polarisation -V_{POL} peut également être appliquée sur les électrodes E2 des transducteurs 101 des autres colonnes du dispositif. Dans ce cas, la tension O_{LRXi} est représentative de l'onde ultrasonore retour reçue par l'ensemble des transducteurs 101 de la ligne Lᵢ.

Dans l'exemple de la figure 2, à partir de l'instant t6, le procédé se poursuit avec une nouvelle phase d'émission-réception similaire à celle mise en oeuvre à partir de l'instant t0.

Dans l'exemple de la figure 1, la troisième configuration (3) des commutateurs SW peut en outre permettre de commander la matrice de transducteurs 101 à la façon d'une barrette linéaire de transducteurs, pour acquérir une image bidimensionnelle. Pour cela, on peut par exemple commander les commutateurs SW de l'ensemble des lignes Lᵢ de la matrice dans la troisième configuration, de façon à appliquer un même potentiel de polarisation continu GND sur les électrodes E1 de tous les transducteurs. Chaque colonne Cⱼ de la matrice se comporte alors comme un transducteur unique commandé alternativement en émission (le commutateur SW de la colonne étant alors dans la première configuration) et en réception (le commutateur de la colonne étant alors dans la deuxième configuration). On notera que le noeud GND n'est pas nécessairement connecté à la masse mais peut être relié à une borne de fourniture d'un potentiel de polarisation fixe adapté pour la polarisation des transducteurs.

De façon similaire, les commutateurs SW de l'ensemble des colonnes Cⱼ de la matrice peuvent être commandés dans la troisième configuration. Chaque ligne Lᵢ de la matrice se comporte alors comme un transducteur unique commandé alternativement en émission et en réception.

A titre de variante, la troisième configuration (3) des commutateurs SW peut être utilisée en mode matriciel (acquisition d'une image tridimensionnelle) pour appliquer aux transducteurs des tensions de polarisation différentes des niveaux définis par les valeurs hautes et basses des tensions fournies par les circuits d'émission TX.

Dans l'exemple de la figure 1, chaque commutateur SW comprend par exemple des premier, deuxième et troisième interrupteurs ayant chacun un premier noeud de conduction connecté aux électrodes E1 de la ligne correspondante ou aux électrodes E2 de la colonne correspondante, et un deuxième noeud de conduction connecté respectivement à la borne de sortie du circuit d'émission TX de la ligne ou de la colonne correspondante, à la borne d'entrée du circuit de réception RX de la ligne ou de la colonne correspondante, et au noeud GND.

A titre de variante, la troisième configuration des commutateurs SW peut être omise, ce qui permet de simplifier leur réalisation.

Les interrupteurs des commutateurs SW peuvent être réalisés au moyen de transistors, par exemple des transistors MOS. Dans ce cas, les commutateurs sont par exemple intégrés dans une puce semiconductrice distincte du substrat dans et sur lequel sont formés les transducteurs 101. A titre d'exemple, les circuits d'émission RX et de réception TX, le circuit de contrôle CTRL et les commutateurs SW sont intégrés dans une même puce semiconductrice.

Dans un mode de réalisation préféré, les interrupteurs des commutateurs SW sont réalisés en technologie MEMS (de l'anglais "Micro Electro Mechanical System" - système micro-électro-mécanique). Les commutateurs SW sont alors de préférence intégrés de façon monolithique avec la matrice de transducteurs ultrasonores, par exemple tel que décrit dans l'article intitulé "A Fast-Switching (1.35-ps) Low-Control-Voltage (2.5-V) MEMS T/R Switch Monolithically Integrated With a Capacitive Micromachined Ultrasonic Transducer" de Xiao Zhang et al. (Journal of Microelectromechanical Systems PP(99) :1-11 January 2018).

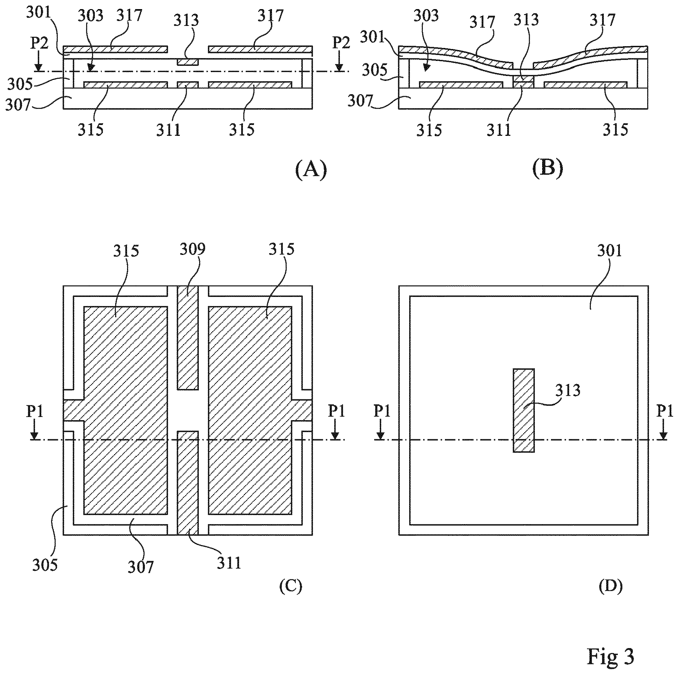

La figure 3 représente de façon schématique un exemple de réalisation d'un tel interrupteur. La figure 3 comprend plus particulièrement deux vues en coupe de côté (A) et (B) de l'interrupteur respectivement à l'état ouvert (bloqué) et à l'état fermé (passant), ainsi qu'une vue en coupe de dessus (C) et une vue en coupe de dessous (D) de l'interrupteur. Les vues (A) et (B) sont des coupes selon le plan P1 des vues (C) et (D), et les vues (C) et (D) sont des coupes selon le plan P2 de la vue (A).

L'interrupteur de la figure 3 comprend une membrane flexible 301 suspendue au-dessus d'une cavité 303 formée dans une couche support rigide 305. La couche 305, par exemple en oxyde de silicium, est disposée sur la face supérieure d'un substrat de support 307, par exemple en verre. Dans l'exemple représenté, la cavité 303 est traversante, c'est-à-dire que le fond de la cavité est constitué par la face supérieure du substrat 307.

L'interrupteur de la figure 3 comprend, disposées sur et en contact avec le fond de la cavité 303, deux métallisations 309 et 311 disjointes, constituant les deux bornes de conduction principales de l'interrupteur. L'interrupteur de la figure 3 comprend en outre, disposée sur et en contact avec la face inférieure de la membrane 301, une métallisation de liaison 313 disposée de façon que, lorsque la membrane 301 est dans une première position appelée position haute, correspondant à la vue (A) de la figure 3, la métallisation 313 ne soit pas en contact avec les métallisations 309 et 311, et, lorsque la membrane 301 est dans une deuxième position appelée position basse, correspondant à la vue (B) de la figure 3, la métallisation 313 connecte l'une à l'autre les métallisations 309 et 311. Ainsi, en position haute de la membrane 301, l'interrupteur est à l'état ouvert, et, en position basse de la membrane 301, l'interrupteur est à l'état fermé.

L'interrupteur comprend une première électrode de commande 315 disposée sur et en contact avec le fond de la cavité 303 et isolée électriquement des métallisations 309 et 311, et une deuxième électrode de commande 317 disposée sur et en contact avec la face supérieure de la membrane 301 et isolée électriquement de la métallisation de liaison 313.

L'application d'une tension de commande appropriée entre les électrodes 315 et 317 conduit à placer la membrane en position basse par effet électrostatique, et donc à fermer l'interrupteur. En l'absence de tension entre les électrodes 315 et 317, la membrane revient en position haute, entraînant l'ouverture de l'interrupteur.

La membrane flexible 301 peut être en silicium et/ou en oxyde de silicium. De préférence, la membrane 301 comprend au moins une couche isolante, par exemple en oxyde de silicium, assurant une isolation électrique d'une part entre l'électrode de commande supérieure 317 et la métallisation 313, et d'autre part entre l'électrode de commande supérieure 317 et l'électrode de commande inférieure 315. A titre d'exemple, la membrane flexible 301 comprend un empilement (non détaillé sur la figure) d'une couche de silicium et d'une couche isolante, par exemple en oxyde de silicium, revêtant la face inférieure de la couche de silicium.

Par ailleurs, afin d'éviter toute perturbation du signal transmis entre les métallisations 309 et 311 en passant par la métallisation 313, l'électrode de commande supérieure 317 est de préférence interrompue en vis-à-vis des métallisations 309, 311 et 313.

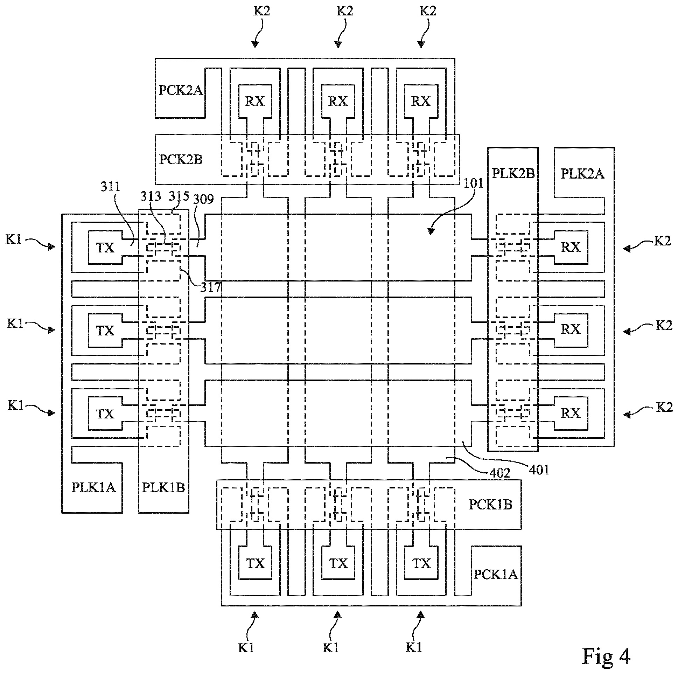

La figure 4 est une vue de dessus illustrant de façon schématique un exemple de co-intégration, sous forme monolithique sur un même substrat de support 307 (non visible sur la figure 4), de la matrice de transducteurs ultrasonores 101 et des commutateurs SW du dispositif 100 de la figure 1. A titre d'exemple, les circuits d'émission RX et de réception TX et le circuit de contrôle CTRL (non visibles sur la figure 4) sont intégrés dans une ou plusieurs puces semiconductrices distinctes de la puce monolithique intégrant les transducteurs 101 et les commutateurs SW.

Dans cet exemple, par souci de simplification, on a considéré une matrice de 3*3 transducteurs ultrasonores 101.

Chaque transducteur présente une structure similaire à celle de l'interrupteur de la figure 3, à la différence près que, dans les transducteurs 101, les métallisations de conduction 309 et 311 et la métallisation de liaison 313 ne sont pas présentes. Dans chaque transducteur 101, les électrodes de commande inférieure 315 et supérieure 317 correspondent respectivement aux électrodes E2 et E1 de la figure 1.

Dans l'exemple de la figure 4, dans chaque ligne Lᵢ de la matrice de transducteurs, les électrodes de commande supérieures des transducteurs 101 de la ligne, correspondant aux électrodes E1, sont connectées les unes aux autres et forment une bande métallique continue 401 s'étendant sur sensiblement toute la longueur de la ligne. De plus, dans chaque colonne Cⱼ de la matrice de transducteurs, les électrodes de commande inférieures des transducteurs 101 de la ligne, correspondant aux électrodes E2, sont connectées les unes aux autres et forment une bande métallique continue 402 s'étendant sur sensiblement toute la longueur de la colonne. Dans cet exemple, les bandes métalliques 401 sont parallèles entre elles, et les bandes métalliques 402 sont parallèles entre elles et perpendiculaires aux bandes 401.

Dans l'exemple de la figure 4, pour chaque ligne Lᵢ de la matrice de transducteurs, le dispositif comprend un premier interrupteur K1 disposé à une première extrémité de la bande métallique 401 de la ligne, et un deuxième interrupteur K2 disposé à l'extrémité opposée de la bande métallique 401 de la ligne. Les interrupteurs K1 et K2 sont des interrupteurs MEMS du type décrit en relation avec la figure 3. Chacun des interrupteurs K1 et K2 a sa métallisation de conduction 309 connectée à la bande métallique 401. La métallisation de conduction 311 de l'interrupteur K1 est connectée à un plot métallique TX destiné à être connecté à la borne de sortie du circuit d'émission TX de la ligne. La métallisation de conduction 311 de l'interrupteur K2 est quant à elle connectée à un plot métallique RX destiné à être connecté à la borne d'entrée du circuit de réception RX de la ligne.

Dans l'exemple de la figure 4, le dispositif comprend en outre, pour chaque colonne Cⱼ de la matrice de transducteurs, un premier interrupteur K1 disposé à une première extrémité de la bande métallique 402 de la colonne, et un deuxième interrupteur K2 disposé à l'extrémité opposée de la bande métallique 402 de la colonne. Chacun des interrupteurs K1 et K2 a sa métallisation de conduction 309 connectée à la bande métallique 402. La métallisation de conduction 311 de l'interrupteur K1 est connectée à un plot métallique TX destiné à être connecté à la borne de sortie du circuit d'émission TX de la colonne. La métallisation de conduction 311 de l'interrupteur K2 est quant à elle connectée à un plot métallique RX destiné à être connecté à la borne d'entrée du circuit de réception RX de la colonne.

Pour chaque ligne Lᵢ, les interrupteurs K1 et K2 de la ligne forment le commutateur SW de la ligne. De même, pour chaque colonne Cⱼ, les interrupteurs K1 et K2 de la colonne forment le commutateur SW de la colonne. Dans cet exemple, les commutateurs SW sont des commutateurs à deux positions, commandables uniquement dans les première (1) et deuxième (2) configurations.

Dans l'exemple de la figure 4, les interrupteurs K1 des différentes lignes Lᵢ de la matrice sont tous situés du côté d'un même bord de la matrice, le bord gauche dans l'exemple représenté, et les interrupteurs K2 des différentes lignes Lᵢ de la matrice sont tous situés du côté du bord opposé de la matrice, le bord droit dans l'exemple représenté. De plus, dans cet exemple, les interrupteurs K1 des différentes colonnes Cⱼ de la matrice sont tous situés du côté d'un même bord de la matrice, le bord inférieur dans l'exemple représenté, et les interrupteurs K2 des différentes colonnes Cⱼ de la matrice sont tous situés du côté du bord opposé de la matrice, le bord supérieur dans l'exemple représenté.

Dans l'exemple de la figure 4 :
- les électrodes de commande 315 des interrupteurs K1 des différentes lignes Lᵢ de la matrice sont toutes connectées à un même plot métallique PLK1A et les électrodes de commande 317 des interrupteurs K1 des différentes lignes Lᵢ de la matrice sont toutes connectées à un même plot métallique PLK1B ;
- les électrodes de commande 315 des interrupteurs K2 des différentes lignes Lᵢ de la matrice sont toutes connectées à un même plot métallique PLK2A et les électrodes de commande 317 des interrupteurs K2 des différentes lignes Lᵢ de la matrice sont toutes connectées à un même plot métallique PLK2B ;
- les électrodes de commande 315 des interrupteurs K1 des différentes colonnes Cⱼ de la matrice sont toutes connectées à un même plot métallique PCK1A et les électrodes de commande 317 des interrupteurs K1 des différentes colonnes Cⱼ de la matrice sont toutes connectées à un même plot métallique PCK1B ; et
- les électrodes de commande 315 des interrupteurs K2 des différentes colonnes Cⱼ de la matrice sont toutes connectées à un même plot métallique PCK2A et les électrodes de commande 317 des interrupteurs K2 des différentes colonnes Cⱼ de la matrice sont toutes connectées à un même plot métallique PCK2B.

Les plots métalliques PLK1A, PLK1B, PLK2A, PLK2B, PCK1A, PCK1B, PCK2A, PCK2B sont destinés à être connectés au circuit de contrôle CTRL du dispositif.

Dans cet exemple, les interrupteurs K1 des différentes lignes Lᵢ sont tous commandés simultanément par application d'une tension de commande appropriée entre les plots PLK1A et PLK1B. De plus, les interrupteurs K2 des différentes lignes Lᵢ sont tous commandés simultanément par application d'une tension de commande appropriée entre les plots PLK2A et PLK2B. De plus, les interrupteurs K1 des différentes colonnes Cⱼ sont tous commandés simultanément par application d'une tension de commande appropriée entre les plots PCK1A et PCK1B. De plus, les interrupteurs K2 des différentes colonnes Cⱼ sont tous commandés simultanément par application d'une tension de commande appropriée entre les plots PCK2A et PCK2B. Ceci permet de limiter le nombre de plots de connexion nécessaires pour commander les commutateurs SW, et ainsi de limiter l'encombrement global et le coût du dispositif.

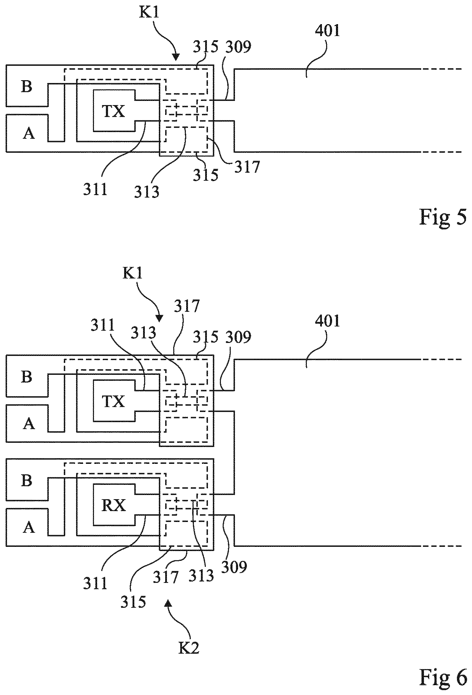

La figure 5 illustre une variante de réalisation du dispositif de la figure 4.

Dans la variante de la figure 5, deux plots métalliques de conduction spécifiques A et B sont prévus pour chacun des interrupteurs K1 et K2 du dispositif, les plots A et B étant connectés respectivement à l'électrode de commande inférieure 315 et à l'électrode de commande supérieure 317 de l'interrupteur. Ceci permet de commander les interrupteurs K1 et K2 de façon individuelle.

Par souci de simplification, seuls un unique interrupteur K1 et une portion de la bande métallique 401 connectée à cet interrupteur sont représentés sur la figure 5.

La figure 6 illustre une autre variante de réalisation du dispositif de la figure 4. Dans l'exemple de la figure 6, pour chaque ligne Lᵢ du dispositif, les interrupteurs K1 et K2 de la ligne sont disposés du côté d'une même extrémité de la ligne Lᵢ. De façon similaire, pour chaque colonne Cⱼ du dispositif, les interrupteurs K1 et K2 de la colonne peuvent être disposés du côté d'une même extrémité de la colonne.

Dans l'exemple de la figure 6, de même que dans l'exemple de la figure 5, deux plots métalliques de conduction spécifiques A et B sont prévus pour chacun des interrupteurs K1 et K2 du dispositif. A titre de variante, les électrodes de commande respectives des interrupteurs K1 et K2 des différentes lignes, et les électrodes de commande respectives des interrupteurs K1 et K2 des différentes colonnes, peuvent être interconnectées de façon similaire à ce qui a été décrit en relation avec la figure 4, de façon à réduire le nombre total de plots de connexion du dispositif.

Par souci de simplification, seuls un unique interrupteur K1, un unique interrupteur K2, et une portion de la bande métallique 401 connectée à ces interrupteurs sont représentés sur la figure 6.

Dans le cas où les commutateurs SW comportent chacun trois interrupteurs, les trois interrupteurs peuvent être disposés du côté d'une même extrémité de la bande métallique 401 ou 402 correspondante. A titre de variante, deux des interrupteurs peuvent être disposés du côté d'une même extrémité de la bande métallique 401 ou 402 correspondante, le troisième interrupteur étant disposé du côté de l'extrémité opposée de la bande métallique. De même que dans l'exemple de la figure 5, deux plots métalliques de conduction spécifiques A et B peuvent être prévus pour chacun des interrupteurs. A titre de variante, les électrodes de commande respectives des interrupteurs des différentes lignes et les électrodes de commande respectives des interrupteurs des différentes colonnes peuvent être interconnectées de façon similaire à ce qui a été décrit en relation avec la figure 4.

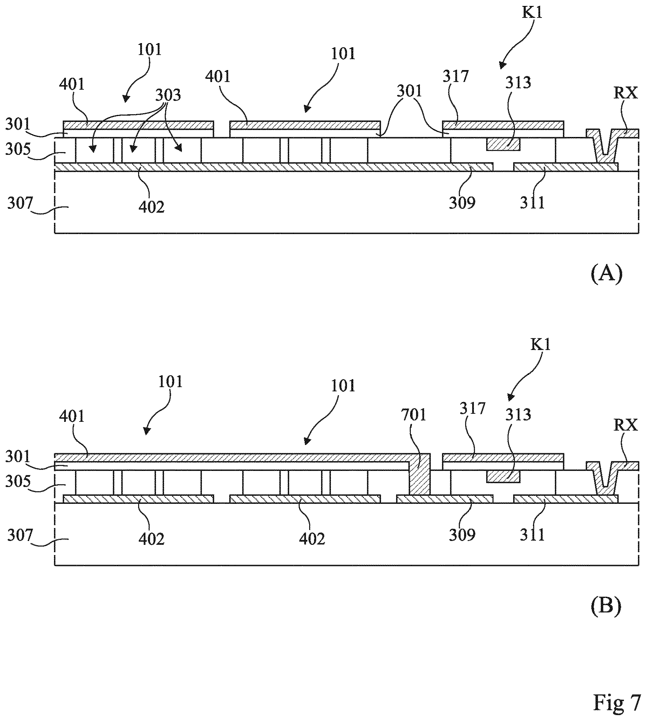

La figure 7 illustre de façon schématique et partielle un exemple de réalisation du dispositif de la figure 4. La figure 7 comprend plus particulièrement une vue (A) représentant une coupe longitudinale dans la direction d'une bande métallique 402 du dispositif, et une vue (B) représentant une coupe longitudinale dans la direction d'une bande métallique 401 du dispositif. Par souci de simplification, sur chaque vue, seuls deux transducteurs 101 et un interrupteur K1 situé à une extrémité de la bande métallique 401 ou 402 correspondante ont été représentés.

Comme cela apparaît sur la figure 7, les transducteurs 101 et les interrupteurs sont formés sur un même substrat de support 307. Les bandes métalliques 402, les électrodes de conduction 309 et 311 des interrupteurs, ainsi que les électrodes de commande inférieures 315 des interrupteurs (non visibles en figure 7), sont formées dans un même premier niveau de métallisation revêtant la face supérieure du substrat 307. La couche support 305 est formée au-dessus du premier niveau de métallisation. La membrane 301 est située au-dessus de la couche support 305. Les bandes métalliques 401 et les électrodes de commande supérieures 317 des interrupteurs sont formées dans un même niveau de métallisation disposé au-dessus de la membrane 301. Chaque bande métallique 401 est connectée à la borne de conduction 309 des interrupteurs du commutateur SW de la ligne correspondante par l'intermédiaire de vias conducteurs 701 traversant la couche membrane 301 et la couche support 305. Les plots de connexion RX et TX (non visibles sur la figure 7) peuvent être formés dans le même niveau de métallisation que les bandes métalliques 401.

On notera que dans l'exemple représenté en figure 7, dans chaque transducteur 101, la cavité 303 au-dessus de laquelle est suspendue la membrane 301 est divisée en une pluralité de cavités élémentaires, par exemple en une matrice de 3*3 cavités élémentaires séparées deux à deux par des parois en le matériau de la couche 305. Les modes de réalisation décrits ne se limitent toutefois pas à ce cas particulier.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que l'on ait décrit ci-dessus uniquement des exemples de réalisation dans lesquels les transducteurs ultrasonores 101 sont des transducteurs CMUT, les modes de réalisation décrits en relation avec les figures 1 et 2 peuvent être adaptés à tout autre type de transducteur nécessitant d'être polarisé à une tension continue lors de l'émission et/ou de la réception d'ondes ultrasonores, par exemple des transducteurs de type PMUT (de l'anglais "Piezoelectric Micromachined Ultrasonic Transducers" - transducteur ultrasonore piézoélectrique micro-usiné).

## Revendications

1. Dispositif d'imagerie ultrasonore (100), comportant :
- une pluralité de transducteurs ultrasonores (101) agencés en matrice selon des rangées (Lᵢ) et des colonnes (Cⱼ), chaque transducteur comportant une première électrode (E1) et une deuxième électrode (E2), les premières électrodes des transducteurs d'une même ligne étant interconnectées et les deuxièmes électrodes des transducteurs d'une même colonne étant interconnectées ;
- pour chaque ligne (Lᵢ), un circuit d'émission (TX), un circuit de réception (RX), et un commutateur (SW) commandable pour, dans une première configuration, connecter les premières électrodes (E1) des transducteurs de la ligne au circuit d'émission (TX) de la ligne, et, dans une deuxième configuration, connecter les premières électrodes (E1) des transducteurs de la ligne au circuit de réception (RX) de la ligne ;
- pour chaque colonne (Cⱼ), un circuit d'émission (TX), un circuit de réception (RX), et un commutateur (SW) commandable pour, dans une première configuration, connecter les deuxièmes électrodes (E2) des transducteurs de la colonne au circuit d'émission (TX) de la colonne, et, dans une deuxième configuration, connecter les deuxièmes électrodes (E2) des transducteurs de la colonne au circuit de réception (RX) de la colonne ; et
- un circuit de contrôle (CTRL) configuré pour :
lors d'une première phase d'émission, commander les commutateurs (SW) d'une ligne (Lᵢ) et d'une colonne (Cⱼ) dans la première configuration, commander le circuit d'émission (TX) de la ligne pour appliquer un signal de polarisation continu sur les premières électrodes (E1) des transducteurs de la ligne (Lᵢ), et commander le circuit d'émission (TX) de la colonne pour appliquer un signal d'excitation variable sur les deuxièmes électrodes (E2) des transducteurs de la colonne (Cⱼ) ; et/ou
lors d'une première phase de réception, commander les commutateurs (SW) d'une ligne (Lᵢ) et d'une colonne (Cⱼ) respectivement dans la première configuration et dans la deuxième configuration, commander le circuit d'émission (TX) de la ligne pour appliquer un signal de polarisation continu sur les premières électrodes (E1) des transducteurs de la ligne (Lᵢ), et commander le circuit de réception (RX) de la colonne pour lire un signal de réponse variable sur les deuxièmes électrodes (E2) des transducteurs de la colonne (Cⱼ).

2. Dispositif selon la revendication 1, dans lequel le circuit de contrôle (CTRL) est en outre configuré pour :
lors d'une deuxième phase d'émission, commander les commutateurs (SW) d'une ligne (Lᵢ) et d'une colonne (Cⱼ) dans la première configuration, commander le circuit d'émission (TX) de la colonne pour appliquer un signal de polarisation continu sur les deuxièmes électrodes (E2) des transducteurs de la colonne (Cⱼ), et commander le circuit d'émission (TX) de la ligne pour appliquer un signal d'excitation variable sur les premières électrodes (E1) des transducteurs de la ligne (Lᵢ) ; et/ou
lors d'une deuxième phase de réception, commander les commutateurs (SW) d'une ligne (Lᵢ) et d'une colonne (Cⱼ) respectivement dans la deuxième configuration et dans la première configuration, commander le circuit d'émission (TX) de la colonne pour appliquer un signal de polarisation continu sur les deuxièmes électrodes (E2) des transducteurs de la colonne (Cⱼ), et commander le circuit de réception (RX) de la colonne pour lire un signal de réponse variable sur les premières électrodes (E1) des transducteurs de la ligne (Lᵢ).

3. Dispositif selon la revendication 1 ou 2, dans lequel :
- dans chaque ligne (Lᵢ), le commutateur (SW) de la ligne est en outre commandable pour, dans une troisième configuration, connecter les premières électrodes (E1) des transducteurs de la ligne à un noeud d'application d'un potentiel de polarisation fixe (GND) ; et
- dans chaque colonne (Cⱼ), le commutateur (SW) de la colonne est en outre commandable pour, dans une troisième configuration, connecter les deuxièmes électrodes (E2) des transducteurs de la colonne audit noeud d'application d'un potentiel de polarisation fixe (GND).

4. Dispositif selon l'une quelconque des revendications 1 à 3, dans lequel :
- les commutateurs (SW) des différentes lignes (Lᵢ) ont des bornes de commande communes ; et
- les commutateurs (SW) des différentes colonnes (Cⱼ) ont des bornes de commande communes.

5. Dispositif selon l'une quelconque des revendications 1 à 4, dans lequel :
- les commutateurs (SW) des différentes lignes (Lᵢ) ont des bornes de commande différenciées ; et
- les commutateurs (SW) des différentes colonnes (Cⱼ) ont des bornes de commande différenciées.

6. Dispositif selon l'une quelconque des revendications 1 à 5, dans lequel les transducteurs ultrasonores (101) sont des transducteurs CMUT ou des transducteurs PMUT.

7. Dispositif selon l'une quelconque des revendications 1 à 6, dans lequel les commutateurs (SW) sont co-intégrés de façon monolithique avec la matrice de transducteurs ultrasonores (101) .

8. Dispositif selon la revendication 7, dans lequel chaque commutateur (SW) comprend des premier (K1) et deuxième (K2) interrupteurs MEMS à commande électrostatique.

9. Dispositif selon la revendication 8, dans lequel :
- pour chaque ligne (Lᵢ), les premier (K1) et deuxième (K2) interrupteurs du commutateur (SW) de la ligne sont disposés respectivement aux deux extrémités de la ligne (Lᵢ) ; et
- pour chaque colonne (Cⱼ), les premier (K1) et deuxième (K2) interrupteurs du commutateur (SW) de la colonne sont disposés respectivement aux deux extrémités de la colonne (Cⱼ) .

10. Dispositif selon la revendication 8, dans lequel :
- pour chaque ligne (Lᵢ), les premier (K1) et deuxième (K2) interrupteurs du commutateur (SW) de la ligne sont disposés du côté d'une même extrémité de la ligne (Lᵢ) ; et
- pour chaque colonne (Cⱼ), les premier (K1) et deuxième (K2) interrupteurs du commutateur (SW) de la colonne sont disposés du côté d'une même extrémité de la colonne (Cⱼ).

11. Dispositif selon l'une quelconque des revendications 8 à 10, dans lequel chaque commutateur (SW) comprend en outre un troisième interrupteur MEMS à commande électrostatique, et dans lequel :
- pour chaque ligne (Lᵢ), le troisième interrupteur du commutateur (SW) de la ligne est disposé du côté de la même extrémité de la ligne (Lᵢ) que le premier interrupteur (K1) de la ligne, ou du côté de l'extrémité de la ligne (Lᵢ) opposée au premier interrupteur (K1) de la ligne ; et
- pour chaque colonne (Cⱼ), le troisième interrupteur du commutateur (SW) de la colonne est disposé du côté de la même extrémité de la colonne (Cⱼ) que le premier interrupteur (K1) de la colonne, ou du côté de l'extrémité de la colonne (Cⱼ) opposée au premier interrupteur (K1) de la colonne.

## Patentansprüche

1. Ultraschall-Bildgebungsvorrichtung (100), die Folgendes aufweist:
- eine Vielzahl von Ultraschallwandlern (101), die in einer Anordnung von Reihen (Li) und Spalten (Cj) angeordnet sind, wobei jeder Wandler eine erste Elektrode (E1) und eine zweite Elektrode (E2) aufweist, wobei die ersten Elektroden der Wandler einer gleichen Reihe miteinander verbunden sind und wobei die zweiten Elektroden der Wandler einer gleichen Spalte miteinander verbunden sind;
- für jede Reihe (Li) eine Sendeschaltung (TX), eine Empfangsschaltung (RX) und einen Schalter (SW), der steuerbar ist, und zwar in einer ersten Konfiguration, die ersten Elektroden (E1) der Wandler in der Reihe mit der Sendeschaltung (TX) der Reihe zu verbinden und, und zwar in einer zweiten Konfiguration, die ersten Elektroden (E1) der Wandler in der Reihe mit der Empfangsschaltung (RX) der Reihe zu verbinden;
- für jede Spalte (Cj) eine Sendeschaltung (TX), eine Empfangsschaltung (RX) und einen Schalter (SW), der steuerbar ist, und zwar in einer ersten Konfiguration, die zweiten Elektroden (E2) der Wandler in der Spalte mit der Sendeschaltung (TX) der Spalte zu verbinden, und, und zwar in einer zweiten Konfiguration, die zweiten Elektroden (E2) der Wandler in der Spalte mit der Empfangsschaltung (RX) der Spalte zu verbinden; und
- eine Steuerschaltung (CTRL), die eingerichtet ist:
während einer ersten Sendephase die Schalter (SW) einer Reihe (Li) und einer Spalte (Cj) in die erste Konfiguration zu steuern, die Sendeschaltung (TX) der Spalte zu steuern, ein Gleichstrom-Vorspannungssignal an die ersten Elektroden (E1) der Wandler in der Reihe (Li) anzulegen, und die Sendeschaltung (TX) der Spalte zu steuern, ein variables Anregungssignal an die zweiten Elektroden (E2) der Wandler in der Spalte (Cj) anzulegen; und/oder
während einer ersten Empfangsphase die Schalter (SW) einer Reihe (Li) und einer Spalte (Cj) jeweils in die ersten Konfiguration und in die zweite Konfiguration zu steuern, die Sendeschaltung (TX) der Reihe zu steuern, ein Gleichstrom-Vorspannungssignal an die ersten Elektroden (E1) der Wandler in der Reihe (Li) anzulegen, und die Empfangsschaltung (RX) der Spalte zu steuern, ein variables Antwortsignal von den zweiten Elektroden (E2) der Wandler in der Reihe (Cj) zu lesen.

2. Vorrichtung nach Anspruch 1, wobei die Steuerschaltung (CTRL) ferner eingerichtet ist:
während einer zweiten Sendephase die Schalter (SW) einer Reihe (Li) und einer Spalte (Cj) in die erste Konfiguration zu steuern, die Sendeschaltung (TX) der Spalte zu steuern, ein Gleichstrom-Vorspannungssignal an die zweiten Elektroden (E2) der Wandler in der Spalte (Cj) anzulegen, und die Sendeschaltung (TX) der Reihe zu steuern, ein variables Anregungssignal an die ersten Elektroden (E1) der Wandler in der Reihe (Li) anzulegen; und/oder
während einer zweiten Empfangsphase die Schalter (SW) einer Reihe (Li) und einer Spalte (Cj) jeweils in die zweite Konfiguration und in die erste Konfiguration zu steuern, die Sendeschaltung (TX) der Spalte zu steuern, ein Gleichstrom-Vorspannungssignal an die zweiten Elektroden (E2) der Wandler in der Spalte (Cj) anzulegen, und die Empfangsschaltung (RX) der Spalte zu steuern, ein variables Antwortsignal von den ersten Elektroden (E1) der Wandler in der Reihe (Li) zu lesen.

3. Vorrichtung nach Anspruch 1 oder 2, wobei:
- in jeder Reihe (Li) der Schalter (SW) der Reihe ferner steuerbar ist, und zwar in einer dritten Konfiguration, die ersten Elektroden (E1) der Wandler in der Reihe mit einem Knotenpunkt zum Anlegen eines festen Vorspannungspotentials (GND) zu verbinden; und
- in jeder Spalte (Cj) der Schalter (SW) der Spalte ferner steuerbar ist, und zwar in einer dritten Konfiguration, die zweiten Elektroden (E2) der Wandler in der Spalte mit dem Knoten zum Anlegen eines festen Vorspannungspotentials (GND) zu verbinden.

4. Vorrichtung nach einem der Ansprüche 1 bis 3, wobei:
- die Schalter (SW) der verschiedenen Reihen (Li) gemeinsame Steueranschlüsse haben; und
- die Schalter (SW) der verschiedenen Spalten (Cj) gemeinsame Steueranschlüsse haben.

5. Vorrichtung nach einem der Ansprüche 1 bis 4, wobei:
- die Schalter (SW) der verschiedenen Reihen (Li) differenzierte Steueranschlüsse haben; und
- die Schalter (SW) der verschiedenen Spalten (Cj) differenzierte Steueranschlüsse haben.

6. Vorrichtung nach einem der Ansprüche 1 bis 5, wobei die Ultraschallwandler (101) CMUT-Wandler oder PMUT-Wandler sind.

7. Vorrichtung nach einem der Ansprüche 1 bis 6, wobei die Schalter (SW) monolithisch mit der Anordnung von Ultraschallwandlern (101) co-integriert sind.

8. Vorrichtung nach Anspruch 7, wobei jeder Schalter (SW) erste (K1) und zweite (K2) elektrostatisch gesteuerte MEMS-Unterbrecher aufweist.

9. Vorrichtung nach Anspruch 8, wobei:
- für jede Reihe (Li) der erste (K1) und der zweite (K2) Unterbrecher des Schalters (SW) der Reihe jeweils an den beiden Enden der Reihe (Li) angeordnet sind; und
- für jede Spalte (Cj) der ersten(K1) und der zweite (K2) Unterbrecher des Schalters (SW) der Spalte jeweils an den beiden Enden der Spalte (Cj) angeordnet sind.

10. Vorrichtung nach Anspruch 8, wobei:
- für jede Reihe (Li) der erste (K1) und der zweite (K2) Unterbrecher des Schalters (SW) der Reihe auf der Seite eines gleichen Endes der Reihe (Li) angeordnet sind; und
- für jede Spalte (Cj) der erste (K1) und der zweite (K2) Unterbrecher des Schalters (SW) der Spalte auf der Seite eines gleichen Endes der Spalte (Cj) angeordnet sind.

11. Vorrichtung nach einem der Ansprüche 8 bis 10, wobei jeder Schalter (SW) ferner einen dritten elektrostatisch gesteuerten MEMS-Unterbrecher aufweist, und wobei:
- für jede Reihe (Li) der dritte Unterbrecher des Schalters (SW) der Reihe auf der Seite des gleichen Endes der Reihe (Li) wie der erste Unterbrecher (K1) in der Reihe oder auf der Seite des Endes der Reihe (Li) gegenüber dem ersten Unterbrecher (K1) in der Reihe angeordnet ist;
- für jede Spalte (Cj) der dritte Unterbrecher des Schalters (SW) der Spalte auf der Seite des gleichen Endes der Spalte (Cj) wie der erste Unterbrecher (K1) in der Spalte oder auf der Seite des Endes der Spalte (Cj) gegenüber dem ersten Unterbrecher (K1) in der Spalte angeordnet ist.

## Claims

1. Ultrasound imaging device (100), comprising:
- a plurality of ultrasound transducers (101) arranged in an array of rows (Lᵢ) and columns (Cⱼ), each transducer comprising a first electrode (E1) and a second electrode (E2), the first electrodes of the transducers of a same row being interconnected and the second electrodes of the transducers of a same column being interconnected;
- for each row (Lᵢ), a transmit circuit (TX), a receive circuit (RX), and a switch (SW) controllable to, in a first configuration, connect the first electrodes (E1) of the transducers in the row to the transmit circuit (TX) of the row and, in a second configuration, connect the first electrodes (E1) of the transducers in the row to the receive circuit (RX) of the row;
- for each column (Cⱼ), a transmit circuit (TX), a receive circuit (RX), and a switch (SW) controllable to, in a first configuration, connect the second electrodes (E2) of the transducers in the column to the transmit circuit (TX) of the column, and, in a second configuration, connect the second electrodes (E2) of the transducers in the column to the receive circuit (RX) of the column; and
- a control circuit (CTRL) configured to:
during a first transmit phase, control the switches (SW) of a row (Lᵢ) and of a column (Cⱼ) into the first configuration, control the transmit circuit (TX) of the column to apply a DC bias signal on the first electrodes (E1) of the transducers in the row (Lᵢ), and control the transmit circuit (TX) of the column to apply a variable excitation signal on the second electrodes (E2) of the transducers in the column (Cⱼ); and/or
during a first receive phase, control the switches (SW) of a row (Lᵢ) and of a column (Cⱼ) respectively into the first configuration and into the second configuration, control the transmit circuit (TX) of the row to apply a DC bias signal on the first electrodes (E1) of the transducers in the row (Lᵢ), and control the receive circuit (RX) of the column to read a variable response signal from the second electrodes (E2) of the transducers in the row (Cⱼ).

2. Device according to claim 1, wherein the control circuit (CTRL) is further configured to:
during a second transmit phase, control the switches (SW) of a row (Lᵢ) and of a column (Cⱼ) into the first configuration, control the transmit circuit (TX) of the column to apply a DC bias signal on the second electrodes (E2) of the transducers in the column (Cⱼ), and control the transmit circuit (TX) of the row to apply a variable excitation signal on the first electrodes (E1) of the transducers in the row (Lᵢ); and/or
during a second receive phase, control the switches (SW) of a row (Lᵢ) and of a column (Cⱼ) respectively into the second configuration and into the first configuration, control the transmit circuit (TX) of the column to apply a DC bias signal on the second electrodes (E2) of the transducers in the column (Cⱼ), and control the receive circuit (RX) of the column to read a variable response signal from the first electrodes (E1) of the transducers in the row (Lᵢ).

3. Device according to claim 1 or 2, wherein:
- in each row (Lᵢ), the switch (SW) of the row is further controllable to, in a third configuration, connect the first electrodes (E1) of the transducers in the row to a node of application of a fixed bias potential (GND); and
- in each column (Cⱼ), the switch (SW) of the column is further controllable to, in a third configuration, connect the second electrodes (E2) of the transducers in the column to said node of application of a fixed bias potential (GND).

4. Device according to any of claims 1 to 3, wherein:
- the switches (SW) of the different rows (Lᵢ) have common control terminals; and
- the switches (SW) of the different columns (Cⱼ) have common control terminals.

5. Device according to any of claims 1 to 4, wherein:
- the switches (SW) of the different rows (Lᵢ) have differentiated control terminals; and
- the switches (SW) of the different columns (Cⱼ) have differentiated control terminals.

6. Device according to any of claims 1 to 5, wherein the ultrasound transducers (101) are CMUT transducers or PMUT transducers.

7. Device according to any of claims 1 to 6, wherein the switches (SW) are monolithically co-integrated with the array of ultrasound transducers (101).

8. Device according to claim 7, wherein each switch (SW) comprises first (K1) and second (K2) electrostatically-controlled MEMS interrupters.

9. Device according to claim 8, wherein:
- for each row (Lᵢ), the first (K1) and second (K2) interrupters of the switch (SW) of the row are respectively arranged at the two ends of the row (Lᵢ); and
- for each column (Cⱼ), the first (K1) and second (K2) interrupters of the switch (SW) of the column are respectively arranged at the two ends of the column (Cⱼ).

10. Device according to claim 8, wherein:
- for each row (Lᵢ), the first (K1) and second (K2) interrupters of the switch (SW) of the row are arranged on the side of a same end of the row (Lᵢ); and
- for each column (Cⱼ), the first (K1) and second (K2) interrupters of the switch (SW) of the column are arranged on the side of a same end of the column (Cⱼ).

11. Device according to any of claims 8 to 10, wherein each switch (SW) further comprises a third electrostatically-controlled MEMS interrupter, and wherein:
- for each row (Lᵢ), the third interrupter of the switch (SW) of the row is arranged on the side of the same end of the row (Lᵢ) as the first interrupter (K1) in the row, or on the side of the end of the row (Lᵢ) opposite to the first interrupter (K1) in the row;
- for each column (Cⱼ), the third interrupter of the switch (SW) of the column is arranged on the side of the same end of the column (Cⱼ) as the first interrupter (K1) in the column, or on the side of the end of the column (Cⱼ) opposite to the first interrupter (K1) in the column.
